# FASCICULE DE BREVET EUROPEEN

(11) **EP 3 026 711 B1**
(45) Date de publication et mention de la délivrance du brevet: **25.12.2019**
(21) Numéro de dépôt: 15196134.9
(22) Date de dépôt: 24.11.2015
(51) Int. Cl.: H01L 21/336, H01L 29/165, H01L 29/78

(54) **PROCEDE AMELIORE POUR INDUIRE UNE CONTRAINTE DANS UN CANAL DE TRANSISTOR A L'AIDE DE REGIONS SOURCE/DRAIN SACRIFICIELLES ET D'UN REMPLACEMENT DE GRILLE**
VERBESSERTES VERFAHREN ZUR ERZEUGUNG EINER DEHNUNG IN EINEM TRANSISTORKANAL MITHILFE VON OPFER-SOURCE- UND OPFER-DRAIN-SCHICHTEN UND EINEM GATE-AUSTAUSCH
IMPROVED METHOD FOR INDUCING STRAIN IN A TRANSISTOR CHANNEL USING SACRIFICIAL SOURCE/DRAIN REGIONS AND A GATE REPLACEMENT

(30) Priorité: 25.11.2014 FR 1461459
(43) Date de publication de la demande: 01.06.2016
(73) Titulaire: Commissariat à l'Énergie Atomique et aux Énergies Alternatives, 75015 Paris (FR); STMicroelectronics, Inc., Coppell, TX 75019 (US)
(72) Inventeur: REBOH, Shay, 38054 Grenoble (FR); MORIN, Pierre, Albany, NY New York 12208 (US)
(74) Mandataire: Brevalex

(56) Documents cités:
- US-A1- 2005 090 066
- US-A1- 2009 321 843
- US-A1- 2011 269 278
- US-A1- 2012 302 019

## Description

### DOMAINE TECHNIQUE ET ETAT DE LA TECHNIQUE

La présente invention se rapporte au domaine de la microélectronique et, plus particulièrement, à celui des transistors.

Afin d'améliorer les performances d'un transistor, il est bien connu d'introduire une contrainte mécanique dans sa région de canal. Une contrainte en tension est mise en œuvre pour améliorer la mobilité des porteurs électriques dans des transistors de type N tandis qu'une contrainte en compression est générée afin d'améliorer la mobilité des porteurs électriques dans des transistors de type P.

Un procédé pour soumettre une région de canal d'un transistor à une contrainte consiste à former des régions source et drain avec un matériau semi-conducteur ayant un paramètre de maille différent de celui du matériau de la région de canal.

Le document « A Logic Nanotechnology Featuring Strained-Silicon » Scott E. Thompson et al, IEEE ELECTRON DEVICE LETTERS, vol. 25, n° 4, avril 2004 191, présente par exemple un procédé dans lequel une région de canal en silicium (Si) est contrainte en compression par l'intermédiaire de régions de source et drain en silicium-germanium (SiGe).

Le document « Strain Enhanced NMOS Using In Situ Doped Embedded Si1-xCx S/D Stressors With up to 1.5% Substitutional Carbon Content Grown Using a Novel Deposition Process », Peter Verheyen et al., IEEE ELECTRON DEVICE LETTERS, Vol. 29, n° 11, novembre 2008, présente un procédé pour appliquer une contrainte en tension sur une région de canal en Si avec des régions source et drain faites de Silicium dopé au Carbone (Si:C).

Le document US2012/302019 A1 présente une procédure de fabrication d'un transistor comportant des régions de drain de source sacrificielles.

Une façon d'augmenter la contrainte en compression dans le canal d'un transistor de type P avec un canal en silicium à l'aide de régions en silicium-germanium serait d'augmenter la teneur en germanium (Ge) dans l'alliage de silicium-germanium.

Toutefois, des régions en silicium-germanium ayant une teneur en germanium plus élevée sont d'autant plus difficiles à doper. Ainsi, il est difficile d'optimiser la conductivité électrique de régions en silicium-germanium ayant une teneur élevée en germanium.

Afin d'augmenter la contrainte en tension dans le canal d'un transistor de type N avec un canal en silicium à l'aide de régions d'alliage de Silicium dopé au Carbone (Si:C), une solution serait d'augmenter la teneur en carbone (C) dans Silicium dopé au Carbone (Si:C). Toutefois, du silicium dopé au Carbone (Si:C) ayant une teneur élevée en carbone de substitution est thermiquement instable au recuit à haute température. Du silicium dopé au Carbone ayant une teneur élevée en carbone de substitution a en outre difficiles à doper correctement par exemple avec du Phosphore.

Il se pose le problème de trouver un nouveau procédé qui ne comporte pas les inconvénients ci-dessus et permette d'améliorer la contrainte dans des canaux de transistors générée tout en conservant des zones de sources et de drain ayant des propriétés électriques adéquates, notamment en termes de conductivité, de résistance de contact et de courant de fuite au niveau des jonctions.

### EXPOSE DE L'INVENTION

Un but de la présente invention est de proposer un procédé qui permette d'induire une contrainte mécanique élastique dans une structure de canal de transistor par le biais de zones de source et de drain tout en conservant des régions de source et de drain optimisées en termes de propriétés électriques.

Pour cela, on met en œuvre des régions de source et de drain sacrificielles qui sont optimisées pour induire une contrainte dans la région de canal, puis on fixe cette contrainte dans le canal à l'aide de l'empilement de grille, puis on remplace les régions de source et de drain sacrificielles par d'autres régions de source et de drains optimisées en termes de caractéristiques électriques.

Un mode de réalisation de la présente invention concerne ainsi un procédé de réalisation d'au moins une structure semi-conductrice de canal contraint de transistor, comprenant des étapes consistant à :
- former, sur une zone semi-conductrice à base d'un premier matériau semi-conducteur comprenant une région destinée à former une région de canal d'un transistor : un bloc de grille sacrificielle et des espaceurs isolants agencés contre des faces latérales du bloc de grille sacrificielle,
- former des régions sacrificielles de part et d'autre de la zone semi-conductrice, les régions sacrificielles étant à base d'un deuxième matériau semi-conducteur et étant configurées de manière à induire une contrainte dans la zone semi-conductrice, puis, dans cet ordre:
- retirer le bloc de grille sacrificielle,
- remplacer le bloc de grille sacrificielle par un bloc de grille de remplacement entre les espaceurs isolants,
- retirer les régions sacrificielles,
- remplacer les régions sacrificielles par des régions de remplacement disposées de part et d'autre de la zone semi-conductrice, les régions de remplacement étant à base d'un troisième matériau semi-conducteur différent du deuxième matériau semi-conducteur.

Dans un premier temps, les régions sacrificielles sont faites d'un matériau qui est optimisé pour introduire une contrainte dans la zone semi-conductrice destinée à accueillir une région de canal de transistor.

La contrainte est ensuite au moins partiellement fixée ou bloquée par la suppression de la grille sacrificielle et par son remplacement par un autre empilement de grille. On dit alors que la contrainte est mémorisée.

Les régions sacrificielles sont ensuite retirées et remplacées par un autre matériau. Du fait de la mémorisation de contrainte mise en œuvre, on peut choisir comme matériau de remplacement un matériau moins adapté que ne l'est le matériau des régions sacrificielles pour réaliser une mise en contrainte du canal mais ayant par ailleurs d'autres propriétés améliorées par rapport au matériau des régions sacrificielles.

Le matériau de remplacement peut être en particulier optimisé en termes de caractéristiques électriques et/ou de stabilité thermique et/ou être plus facile à doper que le matériau des régions sacrificielles.

Selon une possible mise en œuvre du procédé, le troisième matériau semi-conducteur peut être dopé.

Selon une possibilité de mise en œuvre, le troisième matériau semi-conducteur peut différer du deuxième matériau semi-conducteur notamment de par sa concentration en Germanium, le troisième matériau semi-conducteur et deuxième matériau semi-conducteur ayant des concentrations en Germanium différentes l'une de l'autre.

Avantageusement, les régions sacrificielles sont disposées contre des faces latérales de la zone semi-conductrice.

Avantageusement, les régions de remplacement sont disposées contre des faces latérales de la zone semi-conductrice.

De manière avantageuse, le troisième matériau semi-conducteur est dopé *in situ* durant une formation par épitaxie des régions de remplacement.

Les régions de remplacement peuvent être également dopées par implantation ionique puis recuit thermique.

Selon un possible mode de réalisation, le transistor peut être un transistor de type P, ledit deuxième matériau semi-conducteur étant adapté pour contraindre en compression la zone semi-conductrice.

Dans ce cas, lesdites régions sacrificielles peuvent être des régions à base de Si₁₋ₓGeₓ (avec x > 0) en particulier lorsque ladite zone semi-conductrice est formée de silicium.

Des régions Si₁₋ₓGeₓ sacrificielles peuvent être prévues avec une concentration élevée en germanium afin d'optimiser la contrainte de compression dans la zone en silicium. Par concentration élevée en germanium on entend ici une concentration x telle que x ≥ 35% et de préférence telle que x ≥ 50%.

Dans ce cas, lesdites régions de remplacement peuvent être formées d'un matériau qui est plus facile à doper que du Si₁₋ₓGeₓ, tel que du Si_{1-y}Ge_{y} (avec y < x) ou du silicium.

Selon une possibilité, lesdites régions sacrificielles sont des régions à base de SiₓGe₁₋ₓ formées par condensation de germanium, c'est-à-dire par un procédé dans lequel des régions de silicium-germanium sont formées sur une couche de silicium et ensuite oxydées afin d'induire une diffusion de germanium dans le silicium faisant face aux régions de silicium-germanium qui ne sont pas protégées par un masque.

Selon un autre possible mode de réalisation, le transistor peut être un transistor de type N, le deuxième matériau semi-conducteur étant adapté pour appliquer une contrainte en tension dans la zone semi-conductrice.

Dans ce cas, lesdites régions sacrificielles peuvent être des régions à base de silicium dopé au Carbone (Si:C) en particulier lorsque ladite zone semi-conductrice est formée de silicium. Des régions de Si:C sacrificielles peuvent avoir en particulier une teneur en carbone élevée afin d'optimiser la contrainte en tension dans la zone en silicium.

Les régions de remplacement peuvent ensuite être formées d'un matériau tel que du silicium qui est plus facile à doper et a une meilleure mobilité des électrons et une meilleure stabilité thermique que le Si:C.

Selon une possible mise en œuvre, le procédé peut comprendre en outre, avant la formation des régions sacrificielles, une étape de gravure de la couche semi-conductrice de manière à retirer une épaisseur de la couche semi-conductrice et à révéler des faces latérales de la zone semi-conductrice, les régions sacrificielles étant ensuite formées sur une partie restante amincie de la couche semi-conductrice située de part et d'autre de la zone semi-conductrice, les régions sacrificielles étant agencées contre les faces latérales de la zone semi-conductrice.

Avec un tel procédé, une contrainte plus importante peut être appliquée sur la zone semi-conductrice.

Selon une possible mise en œuvre du procédé, après le remplacement dudit bloc de grille sacrificielle par une grille de remplacement et avant la suppression desdites régions sacrificielles, le procédé peut comprendre en outre une ou plusieurs fois la séquence d'étapes suivantes :
- suppression des espaceurs isolants,
- remplacement des espaceurs isolants par d'autres espaceurs isolants.

Avec un tel procédé, une contrainte augmentée peut être appliquée sur la zone semi-conductrice.

De manière avantageuse, la couche semi-conductrice superficielle fait partie d'un semi-conducteur sur un substrat de type isolant.

La présente invention concerne en outre un dispositif microélectronique produit avec un procédé tel que décrit ci-dessus.

La présente invention concerne en outre un procédé de production d'un dispositif microélectronique à l'aide d'un procédé tel que défini ci-dessus.

### BREVE DESCRIPTION DES DESSINS

D'autres objectifs, caractéristiques et avantages de l'invention ressortiront plus clairement à la lecture de la description ci-après, faite en conjonction avec les dessins annexés sur lesquels :
Les figures 1A à 1I illustrent un premier exemple d'un procédé pour produire au moins une structure semi-conductrice de canal de transistor contraint en compression à l'aide d'une technique de mémorisation de contrainte ;
Les figures 2A à 2E illustrent un deuxième exemple d'un procédé pour produire au moins une structure semi-conductrice de canal de transistor contraint en tension à l'aide d'une technique de mémorisation de contrainte ;
Les figures 3A à 3B illustrent une variante de procédé pour augmenter la contrainte dans le canal du transistor ;
Les figures 4A à 4B illustrent une variante de procédé pour augmenter la contrainte dans le canal du transistor ;
Les figures 5A à 5C illustrent un exemple de procédé pour produire des régions semi-conductrices sacrificielles avec une technique de condensation germanium.

Les différents éléments montrés sur les figures ne sont pas nécessairement à la même échelle, afin de rendre les figures plus lisibles.

En outre, dans la description ci-dessous, les termes qui dépendent de l'orientation, tels que « sous », « sur », « au-dessus », « latéral », etc. s'appliquent à une structure tandis que la structure est orientée de la manière illustrée sur les figures.

### DESCRIPTION DETAILLEE DE MODES DE REALISATION PARTICULIERS

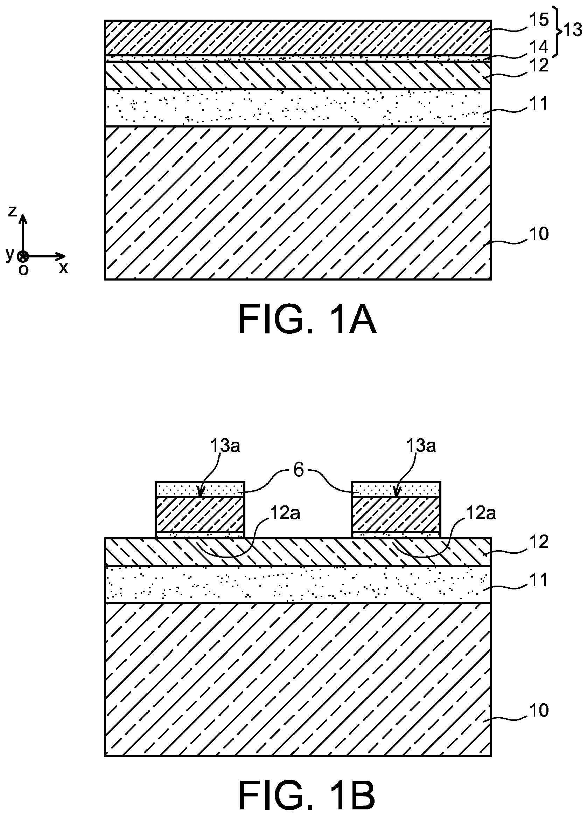

Un exemple de procédé pour réaliser au moins une structure semi-conductrice de canal de transistor contraint sera décrit en faisant référence aux figures 1A à 1I.

Un tel procédé peut être appliqué pour former un transistor de type P ayant un canal de transistor contraint en compression.

Le matériau de départ peut être un substrat du type semi-conducteur sur isolant, qui comprend une couche de support semi-conductrice 10, une couche isolante 11 qui recouvre la couche de support 10, et une couche semi-conductrice superficielle 12 située sur la couche isolante 11 et qui est en contact avec cette couche isolante 11.

Un exemple de substrat de type semi-conducteur sur isolant est le substrat SOI (SOI de l'anglais « Silicon On Insulator » pour silicium sur isolant), dans lequel la couche semi-conductrice superficielle 12 est du Si et la couche isolante 12 appelée communément couche BOX (BOX de l'anglais « buried oxide » pour oxyde enterré) est à base d'un dioxyde de silicium.

La couche isolante 11 peut avoir une épaisseur entre 10 nm et 150 nm par exemple. La couche semi-conductrice superficielle 12 peut par exemple avoir une épaisseur entre 10 nm et 100 nm.

De manière avantageuse, le transistor peut être réalisé selon une technologie FDSOI UTBB (FDSOI de l'anglais « Fully Depleted Silicon on Insulator » pour silicium sur isolant complètement déserté et UTBB de l'anglais « ultra-thin-body-and-box » pour corps ultramince et oxyde enterré). Dans ce cas, la couche isolante 11 peut avoir une épaisseur entre 5 nm et 35 nm par exemple, tandis que la couche semi-conductrice superficielle 12 peut avoir une épaisseur par exemple comprise entre 4 nm et 30 nm.

Une étape de dépôt d'une couche sacrificielle 13 est ensuite effectuée (figure 1A). La couche sacrificielle 13 peut être formée d'un empilement de grille comprenant une couche de diélectrique de grille 14, par exemple du dioxyde de silicium (SiO₂), ayant une épaisseur par exemple entre 1 nm et 5 nm, et une couche de matériau de grille 15, par exemple du polysilicium, ayant une épaisseur entre 20 nm et 80 nm par exemple.

En variante, la couche sacrificielle 13 peut être formée d'un seul matériau tel que du dioxyde de silicium.

Ensuite, un ou plusieurs blocs 13a sont formés dans ladite couche sacrificielle 13. Cela peut être réalisé par exemple par photolithographie et gravure à travers un masque dur 6. Le masque dur 6 peut par exemple être à base de SiO₂ lorsque la couche sacrificielle 13 est formée d'un empilement de grille.

Les blocs 13a forment des grilles que l'on désignera comme *« sacrificielles »* sur des régions 12a de la couche semi-conductrice superficielle 12 dans laquelle des canaux de transistors sont destinés à être réalisés (figure 1B).

Une couche isolante 17 est ensuite déposée afin de recouvrir le sommet et les parois latérales des blocs de grilles sacrificielles 13a. La couche isolante 17 peut être par exemple une couche à base de nitrure de silicium ayant une épaisseur entre 5 nm et 70 nm par exemple.

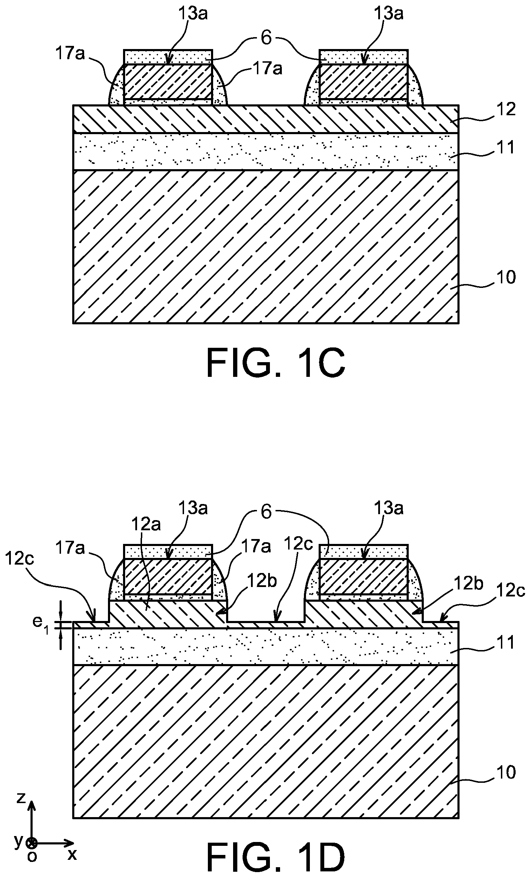

Puis, des espaceurs isolants 17a sont formés sur les parois latérales des blocs de grille sacrificielle 13a, par gravure de la couche isolante 17, par exemple à l'aide d'un procédé de gravure ionique réactive anisotrope (figure 1C).

Une gravure de la couche semi-conductrice superficielle 12 est ensuite effectuée afin de définir des zones semi-conductrices 12b situées sous les blocs de grille sacrificielle 13a et les espaceurs 17a (figure 1D). Les zones semi-conductrices 12b sont délimitées latéralement par des flancs latéraux situés à l'aplomb des espaceurs 17a.

Chaque zone semi-conductrice 12b contient une région 12a destinée à former un canal de transistor. Cette étape de gravure de la couche semi-conductrice superficielle 12 est effectuée sans atteindre la couche isolante 11 de manière à conserver une épaisseur e₁ de la couche semi-conductrice superficielle 12 dans une partie 12c située autour, ou de part et d'autre, des zones semi-conductrices 12b.

La partie 12c amincie de la couche semi-conductrice superficielle 12 a une épaisseur e₁ (l'épaisseur étant mesurée dans une direction z orthogonale au plan principal du substrat, c'est-à-dire un plan du substrat qui est parallèle au plan [0; x; y] du repère orthogonale [O; x; y; z] sur la figure 1D) peut être entre 1 nm et 15 nm par exemple.

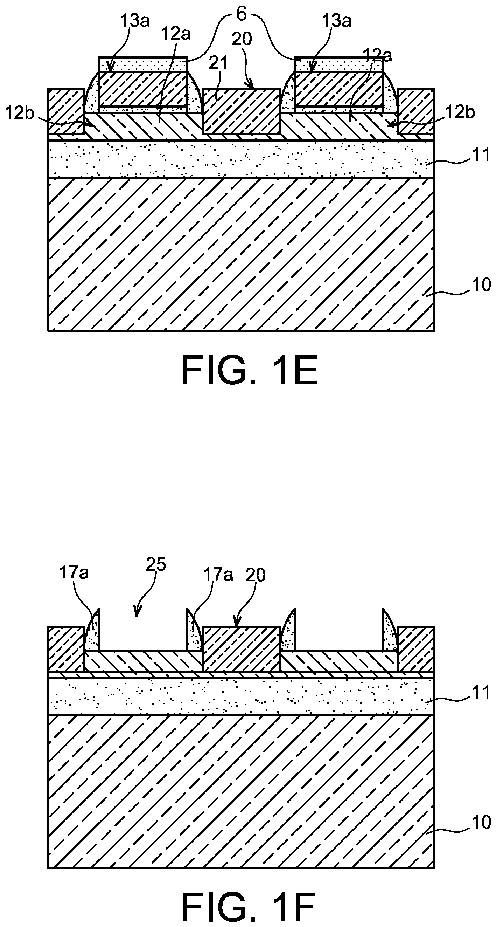

Ensuite, des régions semi-conductrices sacrificielles 20 sont produites par épitaxie sur la partie amincie 12c de la couche semi-conductrice superficielle 12 (figure 1E). Les régions semi-conductrices sacrificielles 20 sont ainsi réalisées de part et d'autre des zones semi-conductrices 12b et accolées à ces zones 12b.

Les régions semi-conductrices sacrificielles 20 sont formées d'un matériau semi-conducteur 21 que l'on appellera *« deuxième matériau semi-conducteur ».* Le deuxième matériau semi-conducteur 21 a un paramètre de maille différent de celui du matériau semi-conducteur constituant les zones semi-conductrices 12b et que l'on appellera *« premier matériau semi-conducteur ».* Le deuxième matériau semi-conducteur 21 est sélectionné ici pour ses propriétés mécaniques plutôt que pour ses propriétés électriques. Ainsi, le deuxième matériau semi-conducteur 21 est de préférence optimisé pour induire une contrainte dans les zones semi-conductrices 12b. Le deuxième matériau semi-conducteur 21 peut ne pas être dopé puisqu'il est destiné à être remplacé. Les régions semi-conductrices sacrificielles 20 sont en contact avec les faces latérales des zones semi-conductrices 12b et sont configurées de sorte à induire une contrainte sur les zones semi-conductrices 12b et plus particulièrement dans une région 12a de ces zones semi-conductrices 12b destinée à former un canal de transistor.

Dans le présent exemple, lorsque des zones semi-conductrices 12b sont à base de silicium, les régions sacrificielles 20 peuvent être formées de Si₁₋ₓGeₓ (avec 0 < x ≤ 1) afin d'induire une contrainte en compression sur les zones semi-conductrices 12b en silicium (figure 1E). Les régions semi-conductrices 20 peuvent être formées avec une concentration élevée en germanium, telle que x > 0.5 par exemple, afin d'obtenir des zones semi-conductrices 12b à forte contrainte en compression. On retire ensuite masque dur 6. Dans le cas où les espaceurs 17a sont à base de nitrure de silicium, et que le masque dur 6 est à base d'oxyde de silicium, on peut effectuer une gravure sélective de l'oxyde de silicium vis-à-vis du nitrure de silicium.

Ensuite, les blocs de grilles sacrificielles 13a entre les espaceurs 17a sont retirés (figure 1F).

Cette étape de retrait aboutit à la formation de cavités 25 entre les espaceurs 17a. Une telle étape de retrait a tendance à éliminer la rigidité imposée par les blocs de grilles sacrificielles 13a et mène à une augmentation de la contrainte induite dans les zones semi-conductrices 12b par les régions semi-conductrices sacrificielles 20. Cette étape de retrait peut être effectuée par exemple par une gravure sélective à l'aide d'une technique NH₄OH afin de supprimer le polysilicium et d'acide fluorhydrique (HF) afin de supprimer le dioxyde de silicium.

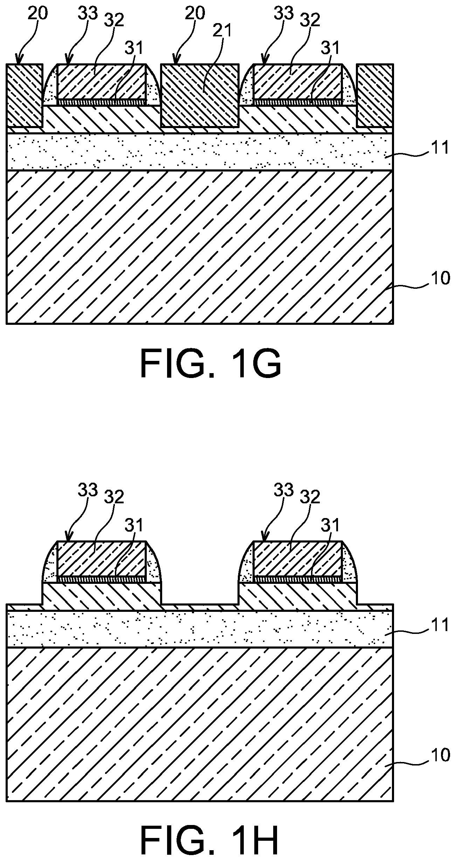

Ensuite, au moins un matériau diélectrique 31 de grille et au moins un matériau 32 de grille sont déposés afin de remplir les cavités 25 et de former des blocs de grille 33 (figure 1G).

Le matériau diélectrique 31 de grille peut être un diélectrique ayant une constante diélectrique élevée, par exemple du dioxyde d'hafnium (HfO₂). Le matériau de grille peut être un matériau à base de semi-conducteur, par exemple du polysilicium ou un matériau métallique, par exemple du nitrure de titane (TiN). En variante, le diélectrique peut être formé d'un empilement de plusieurs couches. Le matériau de grille peut également être formé d'un empilement de plusieurs couches par exemple d'une couche de matériau métallique et d'une couche de matériau semi-conducteur.

Une étape de suppression de matériau en excédent peut ensuite être exécutée par exemple par un procédé CMP (CMP de l'anglais *« Chemical Mechanical Planarization »* pour planarisation chimico-mécanique). Le dépôt de cet empilement de grille *« final* » permet de *« mémoriser »* la contrainte dans la région de grille.

Pour un effet de mémorisation de contrainte accru, des matériaux à module de Young élevé sont favorisés. Plus le module d'Young est élevé plus l'effet de mémorisation étant important. Ainsi, le matériau diélectrique 31 en contact avec la région de canal en silicium 12a est choisi avec un module d'Young plus élevé que celui du matériau de la zone semi-conductrice 12c et de préférence le plus élevé possible. Des matériaux à constante diélectrique élevée, comme du dioxyde d'hafnium ou du HfSiON peuvent être utilisés. De tels matériaux ont généralement un module de Young élevé comparé aux matériaux semi-conducteurs susceptibles d'être employés pour former la zone semi-conductrice 12c.

Les régions semi-conductrices sacrificielles 20 sont ensuite au moins partiellement retirées (figure 1H).

Lorsque des régions semi-conductrices 20 sont à base de Si₁₋ₓGeₓ (avec 0 < x ≤ 1), cette étape de retrait peut être accomplie par une technique de gravure humide à l'aide par exemple d'acide chlorhydrique (HCl) ou d'une solution SC1 (SC1 de l'anglais *« Standard Clean 1 »* pour nettoyage standard 1) typiquement à base de 5H₂O/NH₄OH/H₂O₂. Dans le cas d'un retrait partiel, un tel retrait partiel peut être effectué par une technique de gravure sèche.

Malgré le retrait des régions semi-conductrices sacrificielles 20, grâce aux étapes précédentes de retrait de grille sacrificielle puis de remplacement par un autre empilement de grille, la contrainte induite dans les zones semi-conductrices 12b est au moins partiellement mémorisée.

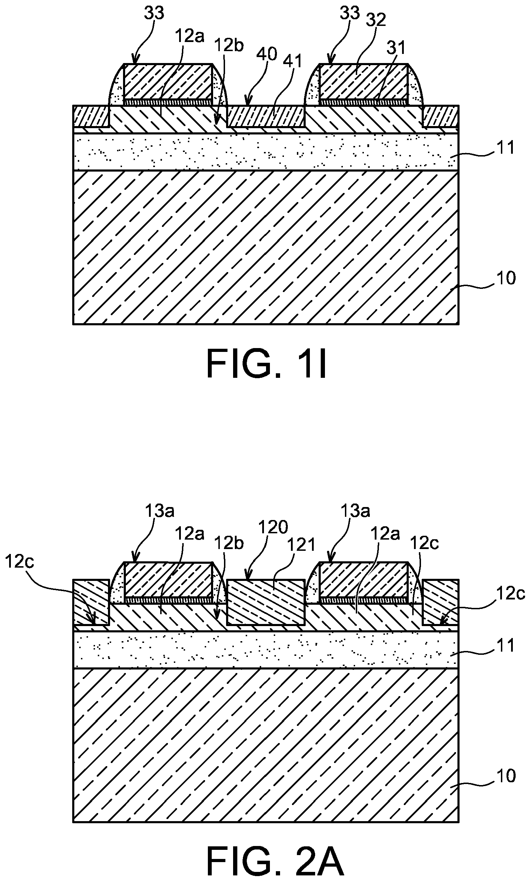

Les régions sacrificielles 20 sont ensuite remplacées par des régions semi-conductrices 40 à base d'un matériau semi-conducteur 41 appelé *« troisième matériau semi-conducteur »* et qui est différent du deuxième matériau semi-conducteur 21 (figure 1I). Tandis que le choix du deuxième matériau semi-conducteur 21 est dicté en considérant la configuration mécanique de la structure, le troisième matériau semi-conducteur 41 est quant à lui sélectionné pour ses propriétés électriques en termes de conductivité, capacités parasites, courants de fuites au niveau des jonctions, résistance de contact.

Ainsi, le troisième matériau semi-conducteur 41 peut être un matériau ayant des propriétés électriques plus adaptées que celles du deuxième matériau semi-conducteur 21.

Le troisième matériau semi-conducteur 41 est avantageusement un matériau dopé. Un dopage *in situ* du troisième matériau semi-conducteur 41 peut être accompli durant sa formation par épitaxie.

Le troisième matériau semi-conducteur 41 peut être également choisi de manière à avoir un paramètre de maille adapté pour induire une contrainte dans les zones semi-conductrices 12b.

Dans un cas où le deuxième matériau semi-conducteur 21 est du Si₁₋ₓGeₓ avec une concentration x en Germanium importante par exemple telle que x ≥ 0.6, le troisième matériau semi-conducteur 41 peut être choisi par exemple à base de Si_{1-y}Ge_{y:}B c'est-à-dire sur silicium Germanium dopé au Bore avec une concentration y en germanium (avec 0 < y < 1) qui est inférieure à la concentration x en germanium du deuxième matériau semi-conducteur 21, et avec un dopage au Bore par exemple à un niveau de l'ordre de 1% d'atomes ou de 2% d'atomes. Le troisième matériau semi-conducteur 41 peut éventuellement formé d'une pluralité de couches de SiGe:B avec des compositions de Germanium et de Bore adaptées de manière à maximiser les performances électriques des régions de source drain des jonctions jusqu'au contact.

Selon un autre exemple de réalisation, le troisième matériau semi-conducteur 41 peut être du silicium.

Un autre exemple de procédé pour produire au moins une structure semi-conductrice de canal de transistor contraint est illustré sur les figures 2A à 2D.

Cet autre exemple de procédé peut être mis en œuvre pour former un canal de transistor de type N ayant une région de canal avec une contrainte en tension.

Dans cet exemple, après la formation des blocs de grilles sacrificielles 13a et des espaceurs isolants 17a, et après la gravure de la couche semi-conductrice superficielle 12 afin de former des zones semi-conductrices gravées 12b, des régions semi-conductrices sacrificielles 120 sont formées par épitaxie sur la partie 12c amincie de ladite couche semi-conductrice superficielle 12, située de part et d'autre des zones semi-conductrices gravées 12b (figure 2A).

Les régions semi-conductrices sacrificielles 120 sont formées dans cet exemple d'un matériau semi-conducteur 121 sélectionné pour ses propriétés mécaniques et ayant un paramètre de maille plus petit de celui du matériau semi-conducteur constituant les zones semi-conductrices 12b. Le matériau semi-conducteur 121 est ainsi employé pour induire une contrainte en tension sur les zones semi-conductrices 12b.

Dans le présent exemple, lorsque les zones semi-conductrices 12b sont à base de silicium, les régions sacrificielles 120 peuvent être formées de Silicium dopé au Carbone (Si:C) afin d'induire une contrainte en tension dans les zones 12b de Si. Les régions semi-conductrices 120 peuvent être formées avec une concentration en carbone la plus élevée possible, de manière à obtenir un paramètre de maille le plus réduit possible par rapport à du Si pur et à maximiser ainsi la contrainte en tension dans les zones semi-conductrices 12b.

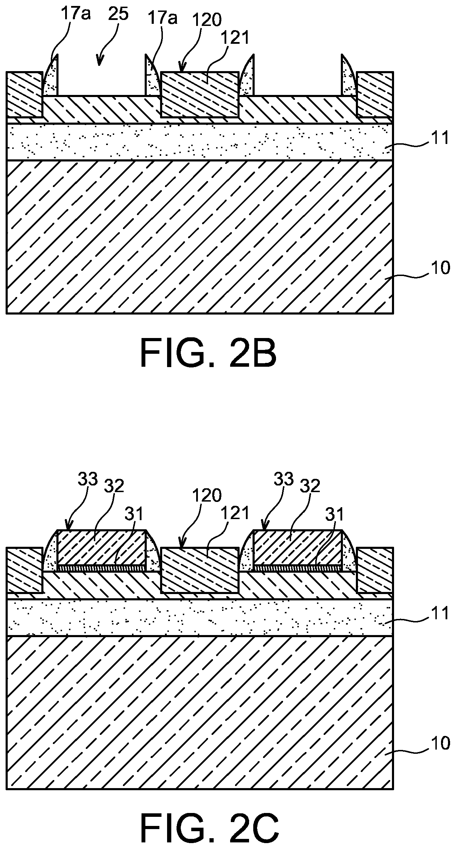

Ensuite, les blocs de grille factice 13a sont retirés (figure 2B) et laissent place à des cavités 25. L'étape de retrait peut être effectuée par exemple par une gravure sélective humide à l'aide de NH₄OH afin de supprimer le polysilicium et d'une solution aqueuse à base de HF afin de supprimer le dioxyde de silicium.

Ensuite, un matériau diélectrique de grille 31 et un matériau de grille 32 sont déposés afin de remplir les cavités 25 et de former des blocs de grille 33. Ces dépôts peuvent être réalisés à basse température, en particulier une température inférieure à 700 °C (figure 2C).

Le matériau diélectrique de grille 31 peut être un matériau ayant une constante diélectrique élevée avec un module de Young élevé, par exemple du dioxyde d'hafnium ou du HfSiON. Le matériau de grille 32 peut être un matériau à base de semi-conducteur, par exemple du polysilicium ou un matériau métallique, par exemple tel que du nitrure de titane, ou un empilement de métal et de semi-conducteur.

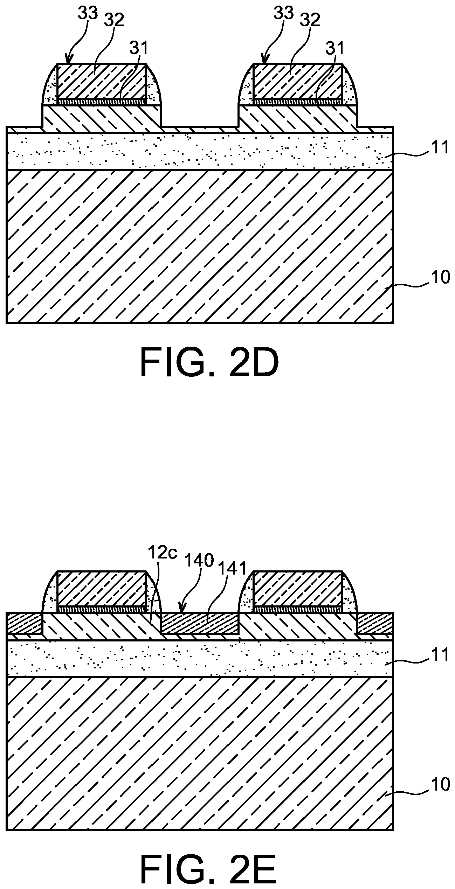

Ensuite, les régions semi-conductrices sacrificielles 120 sont au moins partiellement retirées (figure 2D). Lorsque les régions semi-conductrices 120 sont à base de Silicium dopé au Carbone, cette étape de suppression peut être accomplie, par exemple, par une technique de gravure sèche à l'aide par exemple d'un plasma.

Malgré le retrait des régions semi-conductrices 120, grâce aux étapes précédentes de retrait de grille factice et de remplacement par un autre empilement de grille, la contrainte en tension appliquée dans les zones semi-conductrices 12b est au moins partiellement mémorisée.

Les régions sacrificielles 120 sont ensuite remplacées par des régions semi-conductrices 140 à base d'un matériau semi-conducteur 141 qui est différent du matériau semi-conducteur 121 (figure 2E). Le matériau semi-conducteur 141 de remplacement est sélectionné pour ses propriétés électriques. Ainsi, le matériau semi-conducteur 141 peut être un matériau ayant des propriétés électriques plus favorables, en particulier en ce qui concerne la mobilité des porteurs, que celles du matériau semi-conducteur 121. Le matériau semi-conducteur de remplacement 141 peut être par exemple du silicium. Le matériau semi-conducteur 141 peut être formé par épitaxie à l'aide d'une partie de la couche superficielle 12 en tant que couche germe. Un dopage *in situ* peut être effectué durant l'épitaxie. Le dopage du matériau semi-conducteur 141 peut alternativement être réalisé par implantation ionique.

Avec une méthode telle que décrite précédemment un budget thermique réduit est avantageusement utilisé.

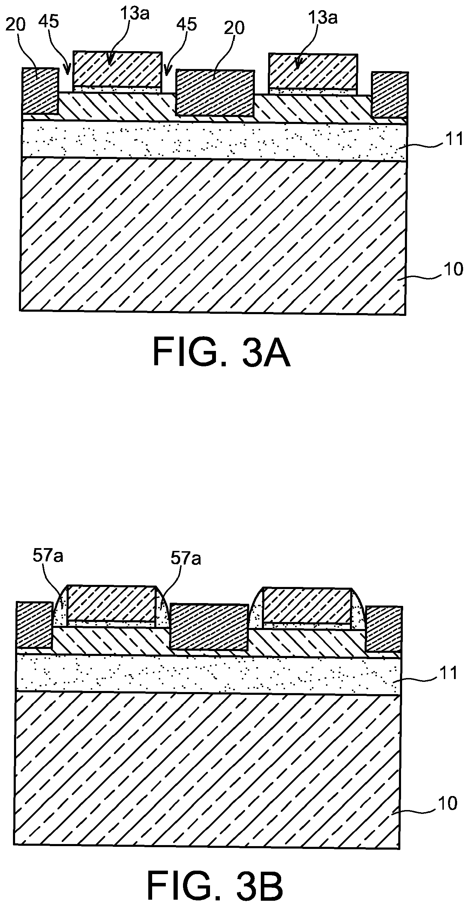

Une variante du procédé qui a été décrit en exemple en liaison avec les figures 1A à 1I, est illustrée sur les figures 3A à 3B.

Une telle variante permet d'augmenter la contrainte induite sur les régions semi-conductrices 12a.

Après l'étape de formation des régions semi-conductrices sacrificielles 20 et ce qui a été décrit en relation avec la figure 1E, les espaceurs 17a sont retirés. Un tel retrait peut être effectué par une gravure sélective à l'aide d'acide phosphorique H₃PO₄ chaud par exemple à 165°C ou d'une solution à base d'HF ultra-dilué lorsque les espaceurs 17a sont à base de nitrure de silicium.

Cette étape de suppression aboutit à la formation d'espaces vides 45 de part et d'autre des blocs 13c de grilles sacrificielles. Une telle étape de suppression a tendance à éliminer la rigidité imposée par les espaceurs 17a et mène à une augmentation de la contrainte induite aux zones semi-conductrices 12b par les régions semi-conductrices sacrificielles 20.

Ensuite, une couche diélectrique, par exemple à base de nitrure de silicium, est déposée afin de remplir les espaces vides 45. Cette couche diélectrique peut être ensuite gravée afin de former des espaceurs isolants de remplacement 57a.

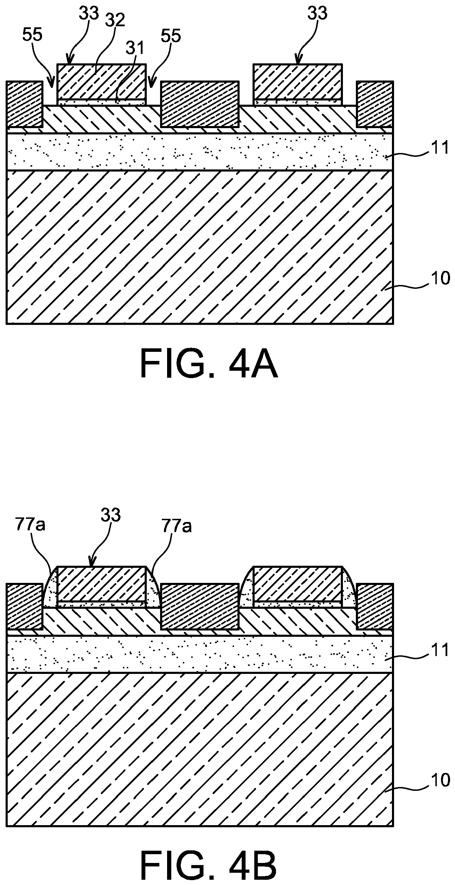

Une autre variante de procédé par exemple de celui qui a été décrit en relation avec les figures 1A à 1I, est illustrée sur les figures 4A à 4B.

Une telle variante permet également d'augmenter la contrainte induite sur les zones semi-conductrices 12b et peut être effectuée en combinaison avec celle décrite plus haut en relation avec les figures 3A à 3B.

Après l'étape de remplacement des blocs de grille factice 13a par des blocs de grille 33 et ce qui a été décrit en relation avec la figure 1G, les espaceurs 17a sont retirés. Un tel retrait peut être effectué par une gravure sélective à l'aide d'acide phosphorique chaud typiquement à 165°C lorsque les espaceurs 17a sont faits de nitrure de silicium. Cette étape de retrait aboutit à la formation d'espaces vides 55 de part et d'autre des blocs 13c de grilles sacrificielles (figure 4A). Une telle étape de retrait a tendance à éliminer la rigidité imposée par les espaceurs 17a et mène à une augmentation de la contrainte induite dans les zones semi-conductrices 12b par les régions semi-conductrices sacrificielles 20.

Ensuite, une couche diélectrique est déposée dans les espaces vides 55 et peut être gravée pour former des espaceurs isolants de remplacement 77a (figure 4B).

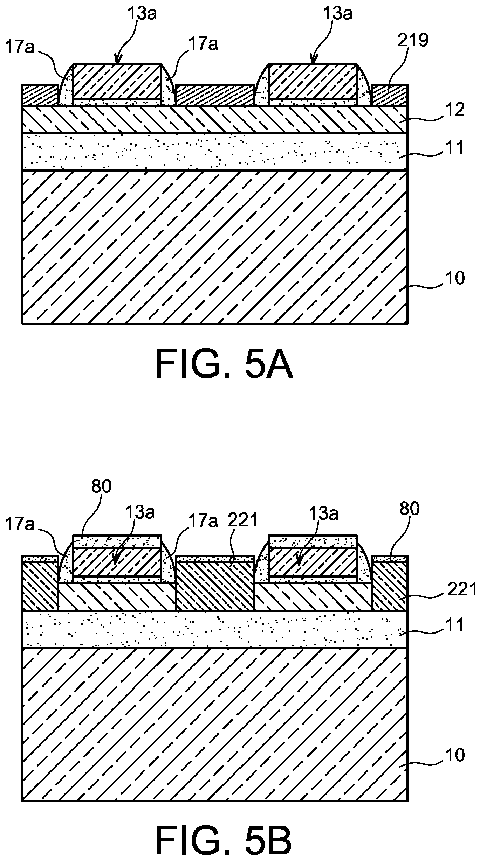

Selon une autre variante des exemples de procédés précédents, les régions sacrificielles réalisées contre les faces latérales de la zone semi-conductrice 12b peuvent être formées par un procédé de condensation de germanium (figures 5A à 5B).

Après la formation des espaceurs isolants 17a, des régions semi-conductrices 219 à base de Si₁₋ₐGeₐ (où 0 < a ≤ 1) sont formées, par exemple par épitaxie de SiGe, sur la partie 12c de la couche semi-conductrice 12 superficielle qui a été amincie et qui se trouve de part et d'autre des zones semi-conductrices 12b que l'on souhaite contraindre (figure 5A).

Ensuite, une étape d'oxydation est exécutée sur les régions 219 à base de Si₁₋ₐGeₐ à une température élevée T, en particulier pour permettre une oxydation maximale de l'alliage de SiGe, par exemple de l'ordre de 1100°C lorsque la fraction a en Ge est de l'ordre de 0.25 ou de 900°C lorsque la fraction a en Ge est de l'ordre de 0.8.

Durant cette étape d'oxydation, les espaceurs isolants 17a et les blocs de grille jouent le rôle de protection contre l'oxydation.

Une fois que l'étape d'oxydation est terminée, des régions 221 à base de Si₁₋ₓGeₓ (avec x >a) sont obtenues sur la partie 12c amincie de la couche semi-conductrice superficielle située de part et d'autre des zones semi-conductrices 12b. Les régions 221 à base de Si₁₋ₓGeₓ peuvent être recouvertes par une couche 80 à base de dioxyde de silicium formée durant l'oxydation (figure 5B).

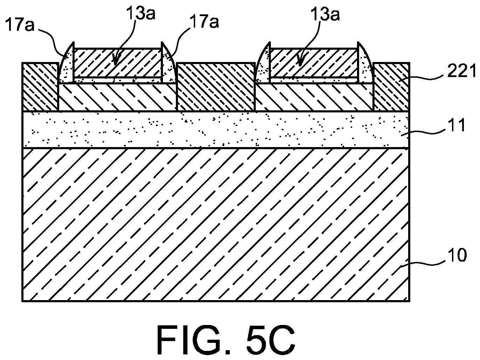

La couche 80 à base de dioxyde de silicium formée durant l'oxydation peut être supprimée par une gravure sélective. Cette gravure sélective peut être exécutée par une gravure humide à l'aide par exemple de HF (figure 5C).

Les procédés qui ont été donnés à titre d'exemple correspondent à une mise en œuvre pour une structure de transistor planaire en technologie CMOS.

Toutefois, un tel procédé peut être appliqué à d'autres types de technologies et à d'autres structures de canal, par exemple afin d'appliquer une contrainte sur des canaux de transistor finFET.

## Revendications

1. Procédé de réalisation d'au moins une structure semi-conductrice de canal contraint d'un transistor, comprenant des étapes de :
- formation, sur une zone semi-conductrice (12b) à base d'un premier matériau semi-conducteur comprenant une région (12a) destinée à former une région de canal d'un transistor : un bloc de grille sacrificielle (13a) et des espaceurs isolants (17a) agencés contre des faces latérales du bloc de grille sacrificielle (13a),
- formation des régions sacrificielles (20, 120) de part et d'autre de la zone semi-conductrice (12b), les régions sacrificielles (20) étant à base d'un deuxième matériau semi-conducteur (21, 121) et étant configurées de manière à induire une contrainte dans la zone semi-conductrice (12b), puis,
dans cet ordre :
- retrait du bloc de grille sacrificielle (13a),
- remplacement du bloc de grille sacrificielle par un bloc de grille de remplacement entre les espaceurs isolants,
- retrait des régions sacrificielles (20),
- remplacement des régions sacrificielles (20) par des régions de remplacement (40, 140) disposées de part et d'autre de la zone semi-conductrice (12b), les régions de remplacement (40, 140) étant à base d'un troisième matériau semi-conducteur (41, 141) différent du deuxième matériau semi-conducteur (21, 121).

2. Procédé selon la revendication 1, le troisième matériau semi-conducteur (41, 141) étant dopé.

3. Procédé selon l'une quelconque des revendications 1 ou 2, dans lequel le transistor est un transistor de type P, le deuxième matériau semi-conducteur (41) étant adapté pour induire une contrainte en compression dans la zone semi-conductrice (12b).

4. Procédé selon la revendication 3, la zone semi-conductrice (12b) appartenant à une couche semi-conductrice en silicium (12), les régions sacrificielles (20) étant des régions à base de Si₁₋ₓ Geₓ (avec x > 0).

5. Procédé selon la revendication 4, les régions sacrificielles (20) étant des régions à base de Si₁₋ₓGeₓ formées par condensation de germanium.

6. Procédé selon l'une des revendications 4 ou 5, les régions de remplacement étant formées de silicium ou de Si_{1-y}Ge_{y} (avec x ≥ y).

7. Procédé selon l'une quelconque des revendications 1 ou 2, dans lequel le transistor est un transistor de type N, le deuxième matériau semi-conducteur (141) étant adapté pour induire une contrainte en tension dans la zone semi-conductrice (12b).

8. Procédé selon la revendication 7, la zone semi-conductrice (12b) appartenant à une couche semi-conductrice en silicium (12), les régions sacrificielles étant des régions à base de Silicium dopé au Carbone (Si:C).

9. Procédé selon la revendication 8, les régions de remplacement étant formées de silicium.

10. Procédé selon la revendication 8, dans lequel les régions de remplacement sont formées par épitaxie durant laquelle un dopage *in-situ* des régions de remplacement est réalisé.

11. Procédé selon la revendication 9, les régions de remplacement étant dopées par implantation ionique puis recuit thermique.

12. Procédé selon l'une des revendications 1 à 11, dans lequel la zone semi-conductrice (12b) appartient à une couche semi-conductrice (12), le procédé comprenant en outre, avant la formation des régions sacrificielles (20), une étape de gravure de la couche semi-conductrice (12) de manière à retirer une épaisseur de la couche semi-conductrice (12) et à révéler les faces latérales de la zone semi-conductrice (12b), les régions sacrificielles (20) étant ensuite formées sur une partie (12c) restante de la couche semi-conductrice de part et d'autre de la zone semi-conductrice (12b), les régions sacrificielles (20) étant disposées contre les faces latérales de la zone semi-conductrice (12b).

13. Procédé selon l'une quelconque des revendications 1 à 12, dans lequel après la formation des régions sacrificielles (20) et avant le retrait de la grille sacrificielle (13a), le procédé comprend une ou plusieurs fois la séquence d'étapes suivante :
- retrait des espaceurs isolants (17a),
- remplacement des espaceurs isolants (17a) par des espaceurs de remplacement (57a).

14. Procédé selon l'une des revendications 1 à 13, **caractérisé en ce que**, après le remplacement du bloc de grille sacrificielle (13a) par une grille de remplacement (33) et avant la suppression des régions sacrificielles (20), le procédé comprend une ou plusieurs fois la séquence d'étapes suivantes :
- retrait des espaceurs isolants (17a, 57a),
- remplacement des espaceurs par d'autres espaceurs isolants (77a).

15. Procédé selon l'une quelconque des revendications 1 à 14, la zone semi-conductrice (12b) appartenant à une couche semi-conductrice superficielle d'un substrat de type semi-conducteur sur isolant.

16. Procédé selon l'une quelconque des revendications 1 à 15, dans lequel les régions sacrificielles sont disposées contre des faces latérales de la zone semi-conductrice.

17. Procédé selon l'une quelconque des revendications 1 à 16, dans lequel les régions de remplacement sont disposées contre des faces latérales de la zone semi-conductrice.

18. Procédé selon l'une quelconque des revendications 1 à 7 et des revendications 12 à 17 dépendantes des revendications 1 à 7, le deuxième matériau semi-conducteur (21, 121) n'étant pas dopé.

## Patentansprüche

1. Verfahren zum Herstellen zumindest einer Halbleiterstruktur für einen Transistorkanal unter mechanischer Spannung, umfassend die Schritte:
- Bilden von einem Opfer-Gate-Block (13a) und von isolierenden Abstandhaltern (17a), die an Seitenflächen des Opfer-Gate-Blocks (13a) angeordnet sind, auf einer Halbleiterzone (12b) auf Basis eines ersten Halbleitermaterials, die einen Bereich (12a) enthält, der dazu bestimmt ist, einen Kanalbereich eines Transistors zu bilden,
- Bilden von Opferbereichen (20, 120) auf beiden Seiten der Halbleiterzone (12b), wobei die Opferbereiche (20) auf Basis eines zweiten Halbleitermaterials (21, 121) bestehen und dazu ausgelegt sind, eine mechanische Spannung in die Halbleiterzone (12b) einzuleiten, dann in dieser Reihenfolge:
- Entfernen des Opfer-Gate-Blocks (13a),
- Ersetzen des Opfer-Gate-Blocks durch einen Ersatz-Gate-Block zwischen den isolierenden Abstandhaltern,
- Entfernen der Opferbereiche (20),
- Ersetzen der Opferbereiche (20) durch Ersatzbereiche (40, 140), die auf beiden Seiten der Halbleiterzone (12b) angeordnet sind, wobei die Ersatzbereiche (40, 140) auf Basis eines dritten Halbleitermaterials (41, 141) bestehen, das sich vom zweiten Halbleitermaterial (21, 121) unterscheidet.

2. Verfahren nach Anspruch 1, wobei das dritte Halbleitermaterial (41, 141) dotiert ist.

3. Verfahren nach einem der Ansprüche 1 oder 2, wobei der Transistor ein P-Transistor ist, wobei das zweite Halbleitermaterial (41) dazu ausgelegt ist, um eine Druckspannung in die Halbleiterzone (12b) einzuleiten.

4. Verfahren nach Anspruch 3, wobei die Halbleiterzone (12b) zu einer Halbleiterschicht aus Silizium (12) gehört, wobei die Opferbereiche (20) Bereiche auf Basis von Si₁₋ₓGeₓ (mit x > 0) sind.

5. Verfahren nach Anspruch 4, wobei die Opferbereiche (20) Bereiche auf Basis von Si₁₋ₓGeₓ sind, die durch Germaniumkondensation gebildet sind.

6. Verfahren nach einem der Ansprüche 4 oder 5, wobei die Ersatzbereiche aus Silizium oder Si_{1-y}Ge_{y} (mit x ≥ y) gebildet sind.

7. Verfahren nach einem der Ansprüche 1 oder 2, wobei der Transistor ein N-Transistor ist, wobei das zweite Halbleitermaterial (141) dazu ausgelegt ist, um eine Zugspannung in die Halbleiterzone (12b) einzuleiten.

8. Verfahren nach Anspruch 7, wobei die Halbleiterzone (12b) zu einer Halbleiterschicht aus Silizium (12) gehört, wobei die Opferbereiche Bereiche auf Basis von kohlenstoffdotiertem Silizium (Si:C) sind.

9. Verfahren nach Anspruch 8, wobei die Ersatzbereiche aus Silizium gebildet sind.

10. Verfahren nach Anspruch 8, wobei die Ersatzbereiche durch Epitaxie gebildet werden, bei der eine in-situ-Dotierung der Ersatzbereiche erfolgt.

11. Verfahren nach Anspruch 9, wobei die Ersatzbereiche durch Ionenimplantation und anschließendes thermisches Glühen dotiert werden.

12. Verfahren nach einem der Ansprüche 1 bis 11, wobei die Hableiterzone (12b) zu einer Halbleiterschicht (12) gehört, wobei das Verfahren ferner vor dem Bilden der Opferbereiche (20) einen Schritt des Ätzens der Halbleiterschicht (12) umfasst, derart, dass eine Dicke der Halbleiterschicht (12) entfernt wird und die Seitenflächen der Halbleiterzone (12b) freigelegt werden, wobei die Opferbereiche (20) dann an einem restlichen Teil (12c) der Halbleiterschicht auf beiden Seiten der Halbleiterzone (12b) gebildet werden, wobei die Opferbereiche (20) an den Seitenflächen der Halbleiterzone (12b) angeordnet werden.

13. Verfahren nach einem der Ansprüche 1 bis 12, wobei nach dem Bilden der Opferbereiche (20) und vor dem Entfernen des Opfer-Gates (13a) das Verfahren ein oder mehrere Male die nachstehende Abfolge von Schritten umfasst:
- Entfernen der isolierenden Abstandhalter (17a),
- Ersetzen der isolierenden Abstandhalter (17a) durch Ersatzabstandhalter (57a).

14. Verfahren nach einem der Ansprüche 1 bis 13, **dadurch gekennzeichnet, dass** nach dem Ersetzen des Opfer-Gate-Blocks (13a) durch ein Ersatz-Gate (33) und vor dem Beseitigen der Opferbereiche (20) das Verfahren ein oder mehrere Male die nachstehende Abfolge von Schritten umfasst:
- Entfernen der isolierenden Abstandhalter (17a, 57a),
- Ersetzen der Abstandhalter durch weitere isolierende Abstandhalter (77a).

15. Verfahren nach einem der Ansprüche 1 bis 14, wobei die Halbleiterzone (12b) zu einer Oberflächenhalbleiterschicht eines Substrats vom Typ Halbleiter auf Isolator gehört.

16. Verfahren nach einem der Ansprüche 1 bis 15, wobei die Opferbereiche an Seitenflächen der Halbleiterzone angeordnet werden.

17. Verfahren nach einem der Ansprüche 1 bis 16, wobei die Ersatzbereiche an Seitenflächen der Halbleiterzone angeordnet werden.

18. Verfahren nach einem der Ansprüche 1 bis 7 und nach den Ansprüchen 12 bis 17 in Abhängigkeit von den Ansprüchen 1 bis 7, wobei das zweite Halbleitermaterial (21, 121) nicht dotiert ist.

## Claims

1. Method of making at least one strained channel semiconducting structure for a transistor, comprising the following steps:
- form a sacrificial gate block (13a) and insulating spacers (17a) arranged in contact with the lateral faces of the sacrificial gate block (13a), on a semiconducting zone (12b) based on a first semiconducting material comprising a region (12a) that will form a transistor channel region (13a),
- form sacrificial regions (20, 120) on each side of the semiconducting zone (12b), the sacrificial regions (20, 120) being based on a second semiconducting material (21, 121) and being configured so as to induce a strain in the semiconducting zone (12b), then,
in this order:
- remove the sacrificial gate block (13a);
- replace the sacrificial gate block (13a) by a replacement gate block between the insulating spacers (17a);
- remove the sacrificial regions (20);
- replace the sacrificial regions (20) by replacement regions located on each side of the semiconducting zone (12b), the replacement regions (40, 140) being based on a third semiconducting material (41, 141) different from the second semiconducting material (21, 121).

2. Method according to claim 1, the third semiconducting material (41, 141) being doped.

3. Method according to any one of claims 1 or 2, in which the transistor is a P type transistor, the second semiconducting material (21, 121) being adapted to strain the semiconducting zone (12b) in compression.

4. Method according to claim 3, the semiconducting zone (12b) forming part of a silicon semiconducting layer (12), the sacrificial regions (20) being Si₁₋ₓ Geₓ-based regions (where x > 0).

5. Method according to claim 4, the sacrificial regions (20) being Si₁₋ₓGeₓ-based regions formed by germanium condensation.

6. Method according to any one of claims 4 or 5, the replacement regions being formed from silicon or Si_{1-y} Ge_{y} (where x ≥ y).

7. Method according to any one of claims 1 or 2, in which the transistor is an N type transistor, the second semiconducting material (21, 121) being adapted to induce a tensile strain in the semiconducting zone (12b).

8. Method according to claim 7, the semiconducting zone (12b) forming part of a silicon semiconducting layer (12), the sacrificial regions (20) being regions based on Carbon-doped silicon (Si:C).

9. Method according to claim 8, the replacement regions being formed from silicon.

10. Method according to claim 8, in which the replacement regions are formed by epitaxy during which *in-situ* doping of replacement regions is performed.

11. Method according to claim 9, the replacement regions being doped by ion implantation followed by thermal annealing.

12. Method according to any one of claims 1 to 11, in which the semiconducting zone (12b) forms part of a semiconducting layer (12), the method further comprising a step to etch the semiconducting layer (12) before the formation of sacrificial regions (20), so as to remove a thickness from the semiconducting layer (12) and to expose lateral faces of the semiconducting zone (12b), the sacrificial regions (20) then being formed on a remaining thinned part of the semiconducting layer located on each side of the semiconducting zone (12b), the sacrificial regions (20) being arranged in contact with the lateral faces of the semiconducting zone (12b).

13. Method according to any one of claims 1 to 12, in which the method further comprises the following sequence of steps once or several times after the formation of sacrificial regions (20) and before removal of the sacrificial gate:
- eliminate the insulating spacers (17a),
- replace the insulating spacers (17a) by replacement spacers (57a).

14. Method according to any one of claims 1 to 13, **characterised in that**, after replacement of the sacrificial gate block (13a) by a replacement gate (33) and before elimination of the sacrificial regions (20), the method comprises the following sequence of steps once or several times:
- eliminate insulating spacers (17a, 57a),
- replace spacers by other insulating spacers (77a).

15. Method according to any one of claims 1 to 14, the semiconducting zone (12b) forming part of a surface semiconducting layer of a semiconductor on insulator type substrate.

16. Method according to any one of claims 1 to 15, in which the sacrificial regions (20) are arranged in contact with the lateral faces of the semiconducting zone (12b).

17. Method according to any one of claims 1 to 16, in which the replacement regions are arranged in contact with the lateral faces of the semiconducting zone (12b).

18. Method according to any one of claims 1 to 7 and any one of claims 12 to 17 depending on claims 1 to 7, the second semiconducting material (21, 121) not being doped.
